# EUROPEAN PATENT APPLICATION

(11) **EP 0 728 716 A1**
(43) Date of publication of application: **28.08.1996**
(21) Application number: 96102686.1
(22) Date of filing: 22.02.1996
(51) Int. Cl.: C04B 35/20, C04B 35/465, H01B 3/12, H01L 23/15, H05K 1/00

(54) **Dielectric ceramic**

(30) Priority: 22.02.1995 JP 34012/95
(71) Applicant: MURATA MANUFACTURING CO., LTD., Nagaokakyo-shi Kyoto-fu 226 (JP)
(72) Inventor: Kanba, Seiji, Nagaokakyo-shi, Kyoto-fu (JP); Takagi, Hiroshi, Nagaokakyo-shi, Kyoto-fu (JP)
(74) Representative: Laufhütte, Dieter, Dr.-Ing.

(57) **Abstract**

A dielectric ceramic containing an oxide is obtained by firing a material comprising Mg and at least one of the elements Si and Ti. The dielectric ceramic can have a graded functional structure such that the dielectric constant of the dielectric ceramic is different in different parts thereof. In the dielectric ceramic, the dielectric constant ε of the dielectric ceramic varies by location in the range 6 to 20.

## Description

### Background of the Invention

This invention relates to a dielectric ceramic, and particularly to a dielectric ceramic used for example in dielectric circuit boards and electronic component packaging.

Dielectric ceramics are widely used as materials for making electronic circuit boards. In many cases, microstrip lines are formed on the surface of a dielectric ceramic processed into a board. The required characteristic impedance of a strip line is realized by controlling the width of the line.

Table 1 shows strip line widths necessary to realize a characteristic impedance of 50Ω for different frequencies of signals passing through the strip line and two different dielectric constants of the dielectric ceramics constituting the circuit boards.

**Table 1**

| 1.5GHz | 12GHz | line width (mm) | conductor loss (db/mm) |
|---|---|---|---|
| ε=17 | | 0.639 | 0.009 |
| ε=60 | | 0.075 | 0.023 |
| | ε=17 | 0.505 | 0.003 |
| | ε=60 | 0.043 | 0.101 |

It will be recognized that the greater is the dielectric constant of the dielectric ceramic, the smaller must be the line width. Reduction in line width is beneficial to high integration of strip lines on the circuit board, but the connection of the strip lines to external wiring such as coaxial cables becomes difficult when the line width is small.

In addition, the greater the signal frequency passing through a circuit, the smaller the line width must be in order to maintain the dielectric constant of the circuit board the same. Accordingly, it becomes difficult to establish connection between external wires and strip lines in a high-frequency circuit board such as one used for a receiver/transmitter for satellite communication.

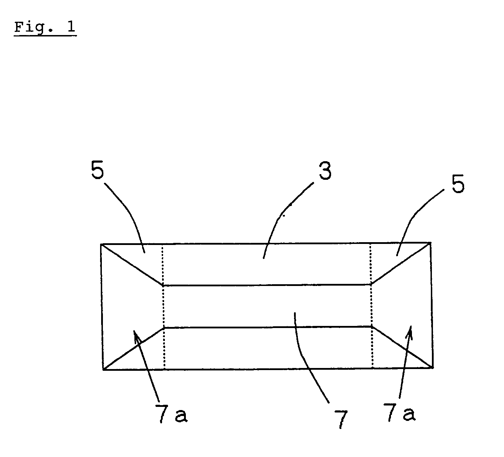

To solve this problem, dielectric ceramics having a graded functional structure are used for circuit boards. As shown in Fig. 1, this kind of dielectric ceramic has different dielectric constants at different locations therein. That is, by making the dielectric constant of edge portions 5 of the board small and making the dielectric constant of a central portion 3 of the board large, connection of strip line end portions 7a to external wires at the edge portions of the board is facilitated and the level of integration of the strip lines 7 can be increased in the central portion of the board.

Conventionally, a dielectric ceramic composition expressed as (Mg₁₋ₓCaₓ)TiO₃ has been used for this type of dielectric ceramic. By changing the value of x, it is possible to realize any dielectric constant ε of the composition in the range 17 ≦ ε ≦ 60. The board is made by laminating together materials of different compositions.

However, it is not possible to realize a strip line width large enough to enable external wires to be connected at frequencies higher than the 1.5 - 12 Ghz range shown in Table 1 at the range of realizable dielectric constants of 17 < ε < 60 in the conventional dielectric ceramic. Also, it is difficult to establish connection with external wires even in the high frequency region shown in Table 1.

### Summary of the Invention

This invention provides an oxide of a Mg/Ti/Si material comprising about 40-60 mol%, preferably about 43-56 mol%, of Mg and about 60-40 mol%, preferably about 43-57 mol%, of at least one of the elements Si and Ti based on the total amount of Mg, Ti and Si. The Si when present is preferably about 15-56 mol% and the Ti when present is preferably about 10-57 mol%. This oxide has a dielectric constant of 6 to 20, which is lower than the range of dielectric constants of the conventional dielectric ceramics. As a result, this oxide can be employed as a material for electronic circuit boards for high-frequency use.

As a result of the low dielectric constant, the strip line width required of strip lines on the board is wider, and even in high-frequency parts it is possible to connect external wires to the strip lines. Also, it is possible to retard increases in conductor losses resulting from reductions in line width.

This invention also provides a dielectric ceramic having a graded functional structure made by combining oxides of materials comprising about 40-60 mol% of Mg and about 60-40 mol% of at least one of the elements Si and Ti.

### Brief Description of the Drawings

Fig. 1 is a plan view of a dielectric board in which a conventional dielectric ceramic is used;
Fig. 2 is a perspective view of a dielectric board in which a dielectric ceramic according to the invention is used;
Fig. 3 is a graph showing dielectric constants at different locations in the dielectric board of Fig. 2;
Fig. 4 is a plan view of a strip line electrode formed on the surface of the dielectric board of Fig. 2; and
Fig. 5 is a perspective view of a stack of green sheets formed in a process for manufacturing the dielectric board of Fig. 2.

### Detailed Description of the Invention

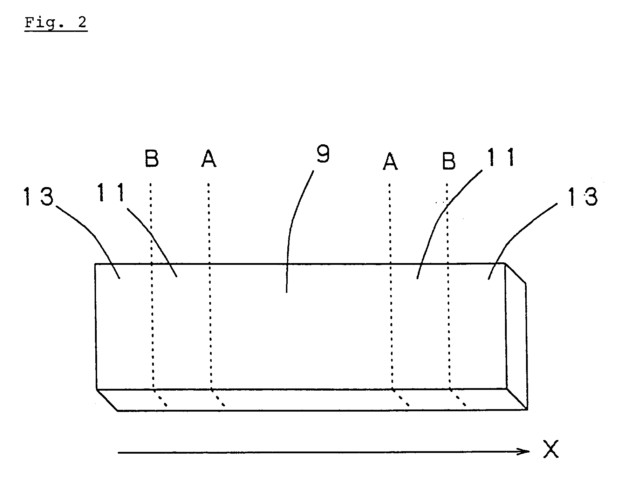

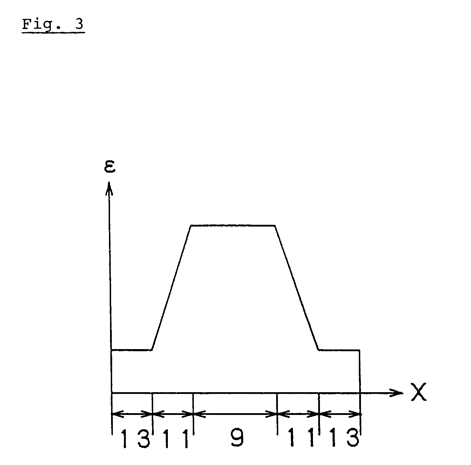

In Fig. 2, a dielectric circuit board according to a preferred embodiment of the invention is made up of five sections. The material composition of section 9 between the dotted lines A and sections 13 on the outer sides of the dotted lines B are respectively uniform. In sections 11 between the dotted lines A and B, on the other hand, the material composition is different in different places. That is, as shown in Fig. 3, the dielectric constant of the board is constant in the sections 13, changes continuously in the sections 11 and is constant at a value higher than in the sections 13 in the central part 9 of the board.

The form of the variation in the dielectric constant in sections 11 depends on the method by which materials of different compositions are combined in those sections of the board, and the variation can be either continuous (microscopically stepped) or stepped.

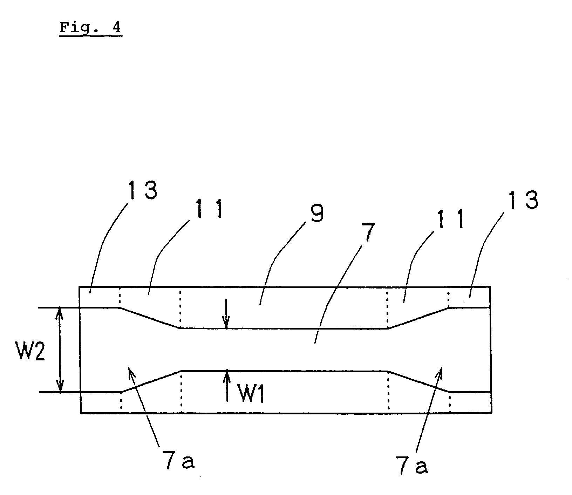

When a strip line of the shape shown in Fig. 4 is formed on a board having this kind of structure, the characteristic impedance of the strip line is the same in all parts of the strip line. In the sections 13 at the ends of the board, the wide line width W2 provides connection spaces 7a for external wires to be attached, and in section 9 in the central part of the board, the narrow line width W1 makes possible high integration of strip lines. A ground electrode is formed on the rear side (not shown in the drawing) of the dielectric board. The dielectric board of Fig. 2 is made up of Mg-Si-Ti-O dielectric ceramics.

Next, a method of manufacturing these dielectric ceramics will be described.

First, Mg(OH)₂, SiO₂ and TiO₂ as starting materials are mixed in the proportions shown in Table 2.

**Table 2**

| composition no. | 1 | 2 | 3 | 4 | 5 | 6 | 7 | 8 | 9 |
|---|---|---|---|---|---|---|---|---|---|
| Mg (mol%) | 44.0 | 45.0 | 55.0 | 40.0 | 45.0 | 40.0 | 55.5 | 45.0 | 43.0 |
| Si (mol%) | 56.0 | 45.0 | 15.0 | 30.0 | 20.0 | 20.0 | - | - | - |
| Ti (mol%) | - | 10.0 | 30.0 | 30.0 | 35.0 | 40.0 | 44.5 | 55.0 | 57.0 |
| ε | 6.0 | 7.7 | 9.5 | 11.3 | 13.0 | 14.8 | 16.5 | 18.3 | 20.0 |
| Qf (x1000GHz) | 17 | 25 | 44 | 32 | 62 | 57 | 195 | 140 | 125 |

The mixtures are then ground in a wet ball mill and powder form raw material mixtures numbered 1 to 9 are obtained.

The raw material mixtures are pre-fired for 3 hours at 1150°C in air, and the pre-fired powders obtained are ground to an average particle diameter of about 1 µm using a wet ball mill.

The powders are each well dried and mixed with an organic solvent (ethanol/toluene = 1/1 v/v), a binder (polyvinyl butylene type), a plasticizer (dioctyl butylate type) and a dispersant (sorbitan fatty acid ester type) to produce a slurry.

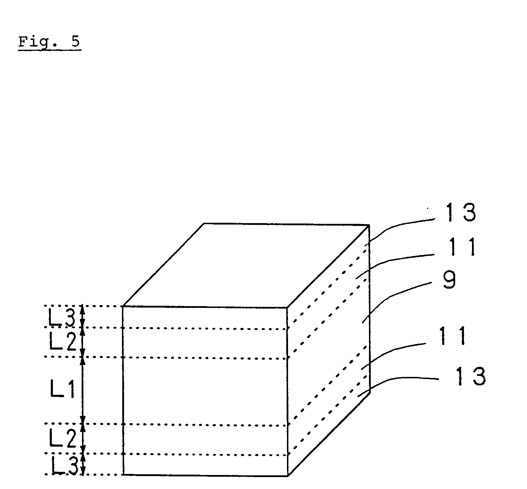

Using the nine slurries thus obtained, nine green sheets having a thickness of 60 µm are made by the doctor blade method and these are laminated together to form the compact shown in Fig. 5. In the compact, the central part 9 consists of green sheets comprising composition no. 9; sections 11 are formed by laminating green sheets comprising composition nos. 2 to 8 sequentially toward the central part 9, and outermost sections 13 consist of green sheets comprising composition no. 1. In this preferred embodiment, the thicknesses of the parts 9, 11 and 13 are L1 = 7.20 mm, L2 = 1.92 mm and L3 = 1.20 mm respectively.

The compact is cut with a diamond cutter, in the direction in which it is laminated, into a sheet having a thickness of 3 mm. The laminate may be of sheet form, rectangular parallelopiped shaped or any other shape.

The cut compact is heated at 500°C in air to remove the organic components. It is then further fired in air for two hours at 1370°C and a sintered body is thereby obtained.

The obtained sintered body is polished to a thickness of 1.2 mm and a surface roughness of about 1 µm and further shaped with a diamond cutter to produce the dielectric board shown in Fig. 2.

It can be confirmed by composition analysis using an X-ray microanalyzer that the above-mentioned sintered body has the kind of graded dielectric constant structure illustrated in Fig. 3.

Next, an Au ground electrode is formed over the whole rear surface of the dielectric board. Also, Au is deposited on the front surface of the dielectric board and by photolithography, a strip line of the pattern shown in Fig. 4 is formed so as to have a characteristic impedance of about 50Ω.

In this preferred embodiment, the widths of the different parts of the strip line electrode are W1 = 0.396 mm and W2 = 1.603 mm. In the sections 11, the strip line width increases toward the edge of the board.

As can be seen from Table 2, when the amounts of Mg, Si and Ti are respectively made about 40-55.5 mol%, 0 to about 56 mol% and 0 to about 57 mol% on the basis that the total of the elements Mg, Si and Ti is 100 mol%, a dielectric ceramic having a low dielectric constant (6 ≦ ε ≦ 20) can be obtained.

Also, by using this kind of composition, a dielectric ceramic in which the product of the Q value and the measured frequency f (GHz) is over 10,000 (GHz) can be obtained.

For comparison, Mg-Ca-Ti-O dielectric ceramics of the compositions shown in Table 3 were made in the same way. Mg(OH)₂, CaCO₃ and TiO₂ were used as the starting materials. These compositions, numbers 10 to 18, were disposed respectively in the same positions in a dielectric board as the compositions numbers 1 to 9 of the invention.

**Table 3**

| composition no. | 10 | 11 | 12 | 13 | 14 | 15 | 16 | 17 | 18 |
|---|---|---|---|---|---|---|---|---|---|
| Mg (mol%) | 55.6 | 51.2 | 48.1 | 44.2 | 42.2 | 40.1 | 37.3 | 35.2 | 33.9 |
| Ca (mol%) | - | 4.1 | 7.1 | 10.2 | 12.0 | 13.4 | 16.4 | 18.3 | 19.5 |
| Ti (mol%) | 44.4 | 44.7 | 44.8 | 45.6 | 45.8 | 46.5 | 46.3 | 46.5 | 46.6 |
| ε | 17.0 | 22.4 | 27.8 | 33.1 | 38.5 | 43.9 | 49.3 | 54.6 | 60.0 |
| Qf (x1000GHz) | 135 | 34 | 19 | 14 | 12 | 10 | 9 | 8 | 8 |

In making this dielectric board, as in the preferred embodiment of the invention described above, green sheets comprising the compositions were laminated into a compact having sections 9, 11 and 13 respectively of thickness L1 = 7.2 mm, L2 = 1.92 mm and L3 = 1.2 mm.

When a strip line was formed on the dielectric board thus obtained by the same procedure as that described above so as to have a characteristic impedance of about 50Ω, the widths of the strip line were W1 = 0.043 mm and W2 = 0.505 mm.

The dielectric circuit board obtained using the compositions shown in Table 3 will hereinafter be referred to as comparison 1.

S21 frequency characteristics, which show transmission loss, are shown in Table 4 for the dielectric circuit board of the preferred embodiment described above and for comparison 1.

**Table 4**

| frequency GHz | 11.0 | 11.5 | 12.0 | 12.5 | 13.0 |
|---|---|---|---|---|---|
| present invention db | -0.3 | -0.4 | -0.5 | -0.5 | -0.6 |
| comparison 1 db | -3.6 | -3.7 | -3.9 | -4.2 | -4.5 |

From Table 4 it can be seen that transmission losses at high frequencies are lower in the circuit board according to the invention than in the board of comparison 1. Therefore, it is possible to provide a dielectric board which has low transmission losses and which makes connection of external wires to strip lines easy using a dielectric ceramic according to the invention.

This invention is not limited to the preferred embodiment described above, and various changes can be made to this preferred embodiment without departing from the scope of the invention.

## Claims

1. A fired dielectric ceramic oxide comprising Mg and at least one of the elements Si and Ti.

2. A dielectric board comprising a dielectric ceramic according to claim 1.

3. A dielectric board according to claim 2 wherein the Mg, Si and Ti amounts are different at a plurality of positions so that the dielectric constant of the dielectric board is different at said positions.

4. A dielectric ceramic according to claim 1 wherein the Mg is about 40-55 mol%, the Si is 0 to about 56 mol% and the Ti is 0 to about 57 mol%, based on the total amount of Mg, Si and Ti.

5. A dielectric board comprising a dielectric ceramic according to claim 4.

6. A dielectric board according to claim 4 wherein the Mg, Si and Ti amounts are different at a plurality of positions so that the dielectric constant of the dielectric board is different at said positions.

7. A dielectric board comprising a plurality of laminated layers of increasing dielectric constant in which each individual layer is a dielectric ceramic according to claim 1.

8. A dielectric board according to claim 7 wherein in each layer the Mg is about 40-55 mol%, the Si is 0 to about 56 mol% and the Ti is 0 to about 57 mol%, based on the total amount of Mg, Si and Ti.

9. A dielectric board according to claim 8 wherein the outermost layers contain no Ti and the centralmost layer contains no Si.
